# FASCICULE DE BREVET EUROPEEN

(11) **EP 3 391 425 B1**
(45) Date de publication et mention de la délivrance du brevet: **27.11.2019**
(21) Numéro de dépôt: 16826296.2
(22) Date de dépôt: 15.12.2016
(51) Int. Cl.: H01L 41/00, C04B 35/00

(54) **PROCEDE DE PREPARATION D'UNE SOLUTION SOL-GEL UTILISABLE POUR LA PREPARATION D'UNE CERAMIQUE DE TITANATE DE BARYUM DOPE PAR DU HAFNIUM ET/OU PAR AU MOINS UN ELEMENT LANTHANIDE**
VERFAHREN ZUR HERSTELLUNG EINER SOL-GEL-LÖSUNG ZUR VERWENDUNG BEI DER HERSTELLUNG EINER MIT HAFNIUM UND/ODER MIT MINDESTENS EINEM LANTHANIDELEMENT DOTIERTEN BARIUMTITANATKERAMIK
METHOD FOR PREPARING A SOL-GEL SOLUTION WHICH CAN BE USED FOR PREPARING A BARIUM TITANATE CERAMIC DOPED WITH HAFNIUM AND/OR WITH AT LEAST ONE LANTHANIDE ELEMENT

(30) Priorité: 15.12.2015 FR 1562398
(43) Date de publication de la demande: 24.10.2018
(73) Titulaire: Commissariat à l'Energie Atomique et aux Energies Alternatives, 75015 Paris (FR)
(72) Inventeur: BOY, Philippe, 37300 Joue-les-tours (FR); RICHARDOT, Thomas, 94400 Vitry Sur Seine (FR); BELLEVILLE, Philippe, 37000 Tours (FR)
(74) Mandataire: Brevalex
(86) Numéro de dépôt international: PCT/EP2016/081136
(87) Numéro de publication internationale: WO 2017/102919

(56) Documents cités:
- EP-A1- 1 449 817
- EP-A2- 1 777 713
- US-A1- 2006 121 258
- US-A1- 2009 135 546
- US-B1- 6 432 472

## Description

### DOMAINE TECHNIQUE

La présente invention a pour objet un procédé de préparation d'une solution sol-gel utilisable pour la préparation d'une céramique de titanate de baryum dopé par du hafnium et/ou par au moins un élément lanthanide (tel que du lanthane, du cérium, de l'europium, du gadolinium).

Les solutions sol-gel de l'invention obtenues par le procédé de l'invention peuvent servir de base directement ou indirectement pour la préparation de différents matériaux, tels que des poudres, des objets compactés (par exemple, des pastilles), des revêtements sous forme de films minces, des solutions sol-gel composites ou encore des revêtements épais préparés à partir desdites solutions sol-gel composites.

Les matériaux obtenus à partir des solutions sol-gel de l'invention peuvent, en particulier, présenter des propriétés piézoélectriques, c'est-à-dire des propriétés qui permettent de transformer l'énergie d'une déformation élastique en énergie électrique. Plus précisément, ces matériaux présentent la capacité à se polariser lorsqu'ils sont contraints mécaniquement, la charge apparaissant à leur surface étant proportionnelle à la déformation engendrée. De tels matériaux peuvent trouver leur application dans des domaines aussi divers que la conception de briquets piézoélectriques, de transducteurs et d'actuateurs, de générateurs ou de récepteurs d'ultrasons ou encore d'interfaces tactiles.

Plus spécifiquement, ils peuvent trouver application dans la conception de transducteurs utilisés dans des sondes ultrasonores haute résolution pour l'imagerie médicale.

### ÉTAT DE LA TECHNIQUE ANTÉRIEURE

Les céramiques du type titanate de baryum dopé par du hafnium ont fait l'objet, dans l'art antérieur, de procédés de préparation par la technique sol-gel.

De manière classique, la technique sol-gel consiste, dans un premier temps, à préparer une solution contenant des précurseurs de la céramique que l'on souhaite obtenir (par exemple, des composés organométalliques, des sels métalliques), formant ainsi un sol (également appelé solution sol-gel). Dans un deuxième temps, lorsque l'on souhaite obtenir un revêtement en céramique, la solution sol-gel est déposée, sous forme d'un film, sur un substrat. Au contact de l'humidité ambiante, les précurseurs s'hydrolysent et se condensent pour former un réseau d'oxyde emprisonnant le solvant, ce qui aboutit à un gel. La couche de gel formant un film est ensuite traitée thermiquement de façon à former un film en céramique.

Cette voie est notamment explorée dans le document US 2007/0131142, qui décrit un procédé de préparation de films minces en titanate de baryum, dont une partie des atomes de titane est substituée par du zirconium, de l'étain ou du hafnium. Pour ce faire, une solution sol-gel est préparée, à partir de précurseurs desdits éléments susmentionnés, dans de l'acide acétique, en présence d'acétonate d'acétyle et de diéthanolamine comme agents complexants. La diéthanolamine est un ligand tridentate, qui a la capacité de réagir avec l'acide acétique pour former un ester ou un aminoester, l'ester ou l'aminoester résultant étant capable de complexer les atomes métalliques entre eux et de les rassembler, pour former des clusters homogènes. Toutefois, il a été constaté par les auteurs de l'invention que l'utilisation d'acétonate d'éthyle, dans ce contexte, réduit l'effet de formation des clusters et empêche, tout particulièrement, la formation de clusters de diamètre supérieur à 2 nm.

Dans Fu et al., Int. J. of Materials Research, 103, 2012, 1400-1403, il est décrit également la préparation d'une céramique du type titanate de baryum dopé par du hafnium et, plus particulièrement, de formule BaHf_{0,1}Ti_{0,9}O₃ utilisant également, outre des précurseurs des éléments métalliques, de l'acétonate d'acétyle et, en fin de synthèse du polyéthylène glycol. Les chaînes de polymère ont pour particularité de s'enrouler autour des ions métalliques, de manière à les écranter les uns avec les autres, avec toutefois pour inconvénient, que ceci représente une lourde charge organique difficile à éliminer. Qui plus est, la concentration des solutions sol-gel obtenues avec ce procédé reste inférieure à 0,5 M.

Au vu de ce qui précède, les inventeurs se sont donc fixé pour objectif de mettre au point un procédé de préparation d'une solution sol-gel précurseur d'une céramique de titanate de baryum dopé par du hafnium et/ou par au moins un élément lanthanide, permettant l'accès à des espèces moléculaires de taille plus importante ainsi qu'à un large panel de concentrations (notamment, des concentrations élevées supérieures à 0,5 M), lesquelles solutions sol-gel pouvant être ensuite utilisées pour la conception de matériaux présentant de bonnes propriétés piézoélectriques.

### EXPOSÉ DE L'INVENTION

Ainsi, l'invention a trait à un procédé de préparation d'une solution sol-gel utilisable pour la préparation d'une céramique de titanate de baryum dopé par du hafnium et/ou par au moins un élément lanthanide comprenant les étapes suivantes :
a) une étape de mise en contact d'un premier mélange comprenant un carboxylate de baryum et un solvant diol et d'un deuxième mélange comprenant un alcoxyde de titane et un alcoxyde de hafnium et/ou un alcoxyde d'un élément lanthanide dans un solvant monoalcoolique ;
b) une étape de distillation du mélange résultant de l'étape a), en vue d'éliminer au moins une partie du solvant monoalcoolique ;
c) une étape d'ajout, à chaud, d'acide acétique au mélange distillé de l'étape b).

On précise que, par titanate de baryum dopé par du hafnium et/ou par au moins un élément lanthanide, on entend du titanate de baryum, dont une partie des atomes de titane est substituée par du hafnium et/ou par au moins un élément lanthanide.

En mettant au point un procédé original de préparation d'une solution sol-gel tel que défini ci-dessus, les auteurs ont pu mettre en évidence la formation d'espèces moléculaires plus grosses dans la solution sol-gel (par exemple, des espèces présentant un diamètre de l'ordre de 2 à 5 nm, alors qu'elles présentent, classiquement, un diamètre inférieur à 2 nm, pour des procédés impliquant l'utilisation de l'acétylacétonate). Le procédé de l'invention permet également d'accéder à des solutions sol-gel présentant un large panel de concentrations et, notamment, des concentrations supérieures à 0,5 M et, plus spécifiquement, allant de 0,5 M à 1 M, sans que cela ne nuise à l'homogénéité de la solution, ceci pouvant être attribué à l'utilisation de l'acide acétique, en fin de procédé, qui permet, entre autres, d'éviter la précipitation d'espèces en solution. Il est à noter que la même quantité d'acide acétique ajoutée avant distillation conduit à un phénomène de précipitation après distillation, d'où l'importance de bien respecter le moment d'ajout de l'acide acétique.

Sans être lié par la théorie, la formation de ces espèces moléculaires de diamètres plus importants peut s'expliquer par la réaction de l'acide acétique avec le solvant diol qui va former des esters, lesquels constituent des complexants bidentates, qui ont la capacité de s'associer, de manière aléatoire aux atomes de baryum et à d'autres atomes (en l'occurrence, ici, le titane, le hafnium et/ou le ou les éléments lanthanides), favorisant ainsi la croissance de clusters en solution et la stabilisation de la solution, laquelle stabilisation résulte aussi du caractère volumineux de ces complexants.

En d'autres termes, pour assurer une distribution aléatoire, les espèces organiques doivent être volumineuses, de façon à «écranter» les atomes métalliques les uns avec les autres et ainsi empêcher toute séparation de phase lors de la formation d'oxyde lors du traitement de la solution sol-gel. Dans le cadre de l'invention, le mélange réactionnel contient de l'acide acétique, un solvant monalcoolique et un solvant diol. L'intérêt du solvant diol est son caractère bidentate, ce qui permet de créer des ponts entre les précurseurs de baryum, de titane, de hafnium et/ou d'élément lanthanide. Sans être lié par la théorie, en réagissant avec l'acide acétique, il peut se former des biacétates, également bidentates, qui se complexent avec les atomes métalliques et permettent un meilleur écrantage entre eux et ainsi une meilleure homogénéisation.

Comme mentionné ci-dessus, le procédé de l'invention comporte une étape a) consistant à mettre en contact un premier mélange comprenant un carboxylate de baryum et un solvant diol et un deuxième mélange comprenant un alcoxyde de titane et un alcoxyde de hafnium et/ou un alcoxyde d'un élément lanthanide dans un solvant monoalcoolique, cette mise en contact pouvant se faire sous agitation.

De préférence, la solution sol-gel préparée selon le procédé de l'invention est destinée à être utilisée pour la préparation d'une céramique de titane de baryum dopée uniquement par du hafnium, auquel cas le deuxième mélange comprend un alcoxyde de titane et un alcoxyde de hafnium dans un solvant monoalcoolique.

Le carboxylate de baryum, comme son nom l'indique, est un composé comprenant du baryum complexé par des ligands appartenant à la catégorie des groupes carboxylates, ce carboxylate de baryum pouvant être représenté par la formule (I) suivante :

(RCOO)₂Ba (I)

dans laquelle R représente un groupe alkyle comprenant de 1 à 3 atomes de carbone.

Plus spécifiquement, le carboxylate de baryum peut être de l'acétate de baryum de formule (CH₃COO)₂Ba.

Le carboxylate de baryum est présent dans un premier mélange comprenant, en outre, un solvant diol, ce solvant diol étant, avantageusement, un alkylène glycol, ayant un nombre d'atomes de carbone allant de 2 à 5 et, plus spécifiquement, de l'éthylène glycol.

L'alcoxyde de hafnium et/ou l'alcoxyde d'élément lanthanide et l'alcoxyde de titane présents dans le deuxième mélange peuvent répondre respectivement aux formules (II) et (III) suivantes : 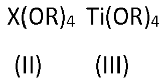 dans lesquelles :
- X représente l'élément hafnium ou l'élément lanthanide ;
- R réprésente un groupe alkyle linéaire ou ramifié et plus spécifiquement un groupe alkyle ramifié comportant au moins 3 atomes de carbone, et plus spécifiquement 3 ou 4 atomes de carbone, un tel groupe pouvant être le groupe isopropyle ou le groupe isobutyle.

Plus spécifiquement, l'alcoxyde de hafnium et l'alcoxyde de titane peuvent être de l'isopropoxyde de hafnium et de l'isopropoxyde de titane.

Ces alcoxydes sont présents dans le deuxième mélange, qui comprend, en outre, un solvant monoalcoolique, et plus spécifiquement, un solvant monoalcoolique aliphatique, pouvant, par exemple, comprendre de 1 à 6 atomes de carbone. A titre d'exemple de monoalcool aliphatique, on peut citer l'isopropanol, particulièrement adapté, lorsque l'alcoxyde de hafnium et l'alcoxyde de titane sont de l'isopropoxyde de hafnium et l'isopropoxyde de titane.

De manière générale, le solvant monoalcoolique comporte, de préférence, un nombre d'atomes de carbone identique à celui de chaque ligand alcoxy (RO) des alcoxydes de formules (II) et (III) susmentionnées, lorsque des alcoxydes répondant à ces formules sont utilisés.

Avant la mise en œuvre de l'étape a), le procédé de l'invention peut comprendre une étape de préparation du premier mélange et une étape de préparation du deuxième mélange, ces étapes consistant, respectivement, à mettre en contact, pour le premier mélange, le carboxylate de baryum avec un solvant diol et, pour le deuxième mélange, l'alcoxyde de titane et l'alcoxyde de hafnium et/ou l'alcoxyde d'élément lanthanide avec un solvant monoalcoolique.

Plus spécifiquement et, à titre d'exemple, lorsque le carboxylate de baryum est l'acétate de baryum, le solvant diol est l'éthylène glycol, l'alcoxyde de hafnium est l'isopropoxyde de hafnium, l'alcoxyde de titane est l'isopropoxyde de titane et le solvant monoalcoolique est l'isopranol, l'étape de mise en contact du premier mélange et du deuxième mélange est effectuée sous agitation pendant une durée d'environ 1 heure, moyennant quoi il résulte une solution blanche opaque.

Après l'étape a), le procédé de l'invention comprend une étape de distillation du mélange résultant de l'étape a), en vue d'éliminer au moins une partie du solvant monoalcoolique et de préférence, de sorte à éliminer au moins 90% de la totalité du volume total du solvant monoalcoolique (à savoir, celui issu du deuxième mélange de départ et celui issu de la décomposition des précurseurs).

Plus spécifiquement, cette étape de distillation consiste à chauffer le mélange de l'étape a) à une température adéquate pour engendrer l'élimination d'au moins une partie du solvant monoalcoolique.

Qui plus est, cette étape de distillation permet de faciliter, le cas échéant, la dissolution de l'alcoxyde de hafnium par changement de coordination du hafnium lors de cette étape, qui s'accompagne concomitamment d'une élimination d'une partie du solvant monoalcoolique, par exemple, au moins 90% de celui-ci, auquel se rajoute l'élimination d'une partie des composés alcooliques issus des ligands alcoxy complexant le hafnium.

Enfin, l'étape de distillation accélère la formation d'esters de diol, lesquels résultent de la réaction du solvant diol avec un composé carboxylate issu du ligand complexant le baryum, ce qui favorise la stabilisation de la solution par le caractère bidentate et volumineux des esters de diol.

A titre d'exemple, lorsque le carboxylate de baryum est l'acétate de baryum, le solvant diol est l'éthylène glycol, l'alcoxyde de hafnium est l'isopropoxyde de hafnium, l'alcoxyde de titane est l'isopropoxyde de titane et le solvant monoalcoolique est l'isopranol, l'étape de distillation peut se dérouler à une température allant jusqu'à 160°C, moyennant quoi 90% de l'isopropanol sont éliminés (comprenant celui issu des précurseurs) et moyennant quoi il se forme des acétates de glycol (à savoir, des esters spécifiques de l'éthylène glycol), qui favorise la stabilisation de la solution.

Après l'étape de distillation, le procédé de l'invention comprend une étape d'ajout, à chaud, d'acide acétique au mélange distillé de l'étape b).

On précise que, par mélange distillé de l'étape b), on entend le mélange d'où a été extrait au moins une partie du solvant monoalcoolique, le solvant monolalcoolique extrait constituant le distillat.

Par étape d'ajout, à chaud, on entend une étape d'ajout s'effectuant à une température supérieure à la température ambiante et, de préférence allant jusqu'à 100 °C.

Aussi, pour la mise en œuvre de cette étape, qui se déroule après l'étape de distillation b), le mélange distillé peut être laissé à refroidir jusqu'à une température supérieure à la température ambiante et, de préférence, allant jusqu'à 100°C.

L'ajout d'acide acétique contribue à la dissolution totale des précurseurs non encore dissous et plus spécifiquement du précurseur de baryum, qui est un carboxylate de baryum.

Sans être lié par la théorie, l'acide acétique réagit avec le solvant diol, par exemple, l'éthylène glycol, pour former des esters qui vont se lier aux atomes de baryum, ce qui génère ainsi des espèces plus solubles. Aussi, l'ajout d'acide acétique contribue ainsi à solubiliser le carboxylate de baryum, tel que l'acétate de baryum, lequel arrive classiquement à saturation dans l'éthylène glycol au-delà de 0,5 M. Ceci permet ainsi d'utiliser des concentrations plus élevées en carboxylate de baryum.

De plus, la formation d'esters résultant de la réaction du solvant, tel que l'éthylène glycol, et de l'acide acétique, lesquels sont des complexants bidendates volumineux contribue à la formation d'espèces moléculaires de diamètres plus importants (par exemple, un diamètre allant de 2 à 5 nm) et une augmentation de la viscosité.

Le procédé de l'invention est particulièrement adapté à la préparation de solutions sol-gel précurseurs de céramiques oxydes répondant à la formule (IV) suivante :

BaHfₓTi₁₋ₓO₃ (IV)

dans laquelle 0,05 <x≤ 0,5 et plus spécifiquement dans laquelle 0,05 <x≤ 0,2.

La solution sol-gel obtenue à l'issue de l'étape c) peut être utilisée directement, par exemple, pour fabriquer des poudres ou peut être utilisée ultérieurement, c'est-à-dire après stockage, au cours duquel la solution peut subir une étape de mûrissement, auquel cas, il peut être avantageux, dans le cadre du procédé de l'invention, de diluer la solution sol-gel à l'issue d'une étape d'agitation de cette solution.

Aussi, dans ce cas, le procédé de l'invention comprend, à l'issue de l'étape c), successivement les étapes suivantes :
d) une étape d'agitation de la solution sol-gel obtenue à l'étape c) ; et
e) une étape de dilution à un taux prédéterminé de la solution sol-gel issue de l'étape d) avec un solvant diol identique à celui de l'étape a).

Cette étape de dilution peut consister à diluer la solution sol-gel obtenue à l'issue de l'étape d) par un facteur de dilution s'échelonnant de 1 à 20 avec un solvant diol identique à celui utilisé dans l'étape a). Cette étape de dilution permet notamment de contrôler la taille des clusters, en fonction de l'usage que l'on souhaite faire de la solution sol-gel.

Les solutions sol-gel obtenues selon le procédé de l'invention peuvent être utilisées pour les destinations suivantes :
- la fabrication d'un matériau céramique, par exemple, sous forme de films minces, par traitement thermique de ladite solution sol-gel ;
- la fabrication de poudres de titanate de baryum dopé par de l'hafnium et/ou par au moins un élément lanthanide, lesquelles poudres peuvent être ensuite utilisées pour constituer des objets compactés, tels que des pastilles ;
- la fabrication d'une solution sol-gel composite, à savoir une solution sol-gel obtenue selon le procédé de l'invention, à laquelle est ajoutée une poudre, ladite solution sol-gel pouvant être ensuite utilisée pour réaliser des revêtements épais.

Aussi l'invention a trait également à un procédé de préparation d'un matériau en titanate de baryum dopé par du hafnium et/ou par au moins un élément lanthanide, ledit procédé comprenant :
f) une étape de mise en œuvre du procédé de préparation d'une solution sol-gel tel que défini ci-dessus ;
g) au moins une étape de dépôt d'une couche d'une solution sol-gel obtenue à l'étape f) sur un substrat;
h) une étape de traitement thermique de ladite au moins une couche en vue de la transformer en titanate de baryum dopé par du hafnium et/ou par au moins un élément lanthanide.

Ainsi, l'étape g) consiste à déposer sur un substrat la solution sol-gel stable, préparée selon le procédé précédemment décrit, sous forme d'une couche.

Ce dépôt peut être effectué par toutes techniques permettant d'obtenir un dépôt sous forme de couches minces. Les épaisseurs de chaque couche mince déposée, selon l'invention, peuvent aller de 10 nm à 500 nm, de préférence, de 50 nm à 100 nm.

Le dépôt peut se faire selon l'une des techniques suivantes :
- le trempage-retrait (connu sous la terminologie anglaise « *dip-coating* ») ;
- l'enduction centrifuge (connue sous la terminologie anglaise « *spin-coating* ») ;
- l'enduction laminaire (connue sous la terminologie anglaise « *laminar-flow-coating* » ou « *meniscus coating* ») ;
- la pulvérisation (connue sous la terminologie anglaise « *spray-coating* ») ;
- l'épandage (connu sous la terminologie anglaise « *soak coating* ») ;
- l'enduction au rouleau (connue sous la terminologie « *roll- to-roll process* ») ;
- l'enduction au pinceau (connue sous la terminologie anglaise « *Paint coating* ») ;
- la sérigraphie (connue sous la terminologie anglaise « *screen printing* ») ; et
- le dépôt par jet d'encre.

Toutefois, de préférence, le dépôt sera réalisé par la technique du trempage-retrait (appelée communément « *dip-coating* » en anglais) ou encore par la technique de l'enduction centrifuge (appelée communément « *spin-coating* » en anglais). Ces techniques facilitent, notamment, un contrôle précis des épaisseurs de couches déposées.

En ce qui concerne la technique de l'enduction centrifuge, le substrat destiné au dépôt est plaqué sur un support tournant. Ensuite, l'on dépose un volume de solution sol-gel permettant de recouvrir ledit substrat. La force centrifuge étale ladite solution sous forme d'une couche mince. L'épaisseur de la couche est notamment fonction de la vitesse de centrifugation et de la concentration de la solution. Le paramètre de la concentration de la solution étant fixé, l'homme du métier peut aisément choisir une vitesse de centrifugation voulue pour une épaisseur de couche désirée.

Selon l'invention, le substrat destiné au dépôt peut être de divers types, mais ne doit pas, de préférence, contaminer la couche déposée, par migrations d'ions par exemple, lors du traitement thermique et doit, de préférence, permettre une bonne adhérence de la couche. Sa température de ramollissement doit être avantageusement supérieure à la température de traitements thermiques des couches déposées et son coefficient de dilatation thermique doit être avantageusement du même ordre de grandeur que celui desdites couches pour limiter les effets de contrainte lors des traitements thermiques.

Selon l'invention, le substrat peut être une tranche de silicium éventuellement revêtue d'une couche métallique. Ce type de substrat présente avantageusement une bonne planéité et un excellent état de surface et permet, notamment, des traitements thermiques à haute température, sans subir d'altérations.

Ce substrat peut comporter une couche barrière sur la ou lesdites faces qui servent de face de dépôt, cette couche barrière ayant pour fonction d'empêcher une migration des atomes du substrat vers la (les) couches déposées obtenues après traitement thermique. Cette couche barrière a également pour fonction de diminuer les pertes diélectriques des matériaux obtenus avec le procédé de l'invention. La couche barrière est déposée préalablement à la mise en œuvre de l'étape g).

Une fois que le dépôt de la solution sol-gel est effectué sur une face du substrat éventuellement recouverte d'une couche barrière, le procédé de l'invention comprend une étape de traitement thermique de la ou les couches déposées, de manière à les transformer en la céramique souhaitée. Ce traitement thermique peut se dérouler de différentes manières, selon que le procédé de l'invention comprend la mise en œuvre d'une ou plusieurs étapes de dépôt g) tels que mentionnées ci-dessus.

Selon le procédé de l'invention, lorsque l'étape g) est mise en œuvre qu'une seule fois, le traitement thermique peut comprendre, de manière générale, successivement les opérations suivantes :
- une opération de séchage de la couche, généralement à une température appropriée pour obtenir une gélification de celle-ci ;
- une opération de calcination, généralement à une température appropriée pour obtenir une élimination des produits organiques compris dans la couche ;
- une opération de recuit, généralement à une température appropriée pour obtenir une cristallisation en céramique oxyde de la couche.

Selon le procédé de l'invention, lorsque l'étape g) est mise en œuvre n fois, n correspond au nombre de répétitions de l'étape g), n étant un entier pouvant aller de 2 à 50, le traitement thermique peut comprendre :
*pour chacune des (n-1) premières couches déposées, un cycle d'opérations comprenant successivement :
   - une opération de séchage de chaque (n-1) couche déposée ;
   - une opération de calcination de chaque (n-1) couche ;
*pour la nième couche déposée, un cycle d'opérations comprenant successivement:
   - une opération de séchage de ladite couche ;
   - une opération de calcination de ladite couche ;
   - une opération de pré-recuit de ladite couche ;
ledit traitement thermique étant finalisé par une opération de recuit de l'ensemble desdites couches déposées (c'est-à-dire des n couches).

En d'autres termes, pour les (n-1) premières couches, chacune desdites couches subira successivement une opération de séchage, une opération de calcination. Puis, la n^{ième} couche déposée sur l'empilement des (n-1) premières couches, subira successivement une opération de séchage suivi d'une opération de calcination et d'une opération de pré-recuit. Enfin, le traitement thermique sera finalisé par une opération de recuit de l'empilement complet.

Quelle que soit l'alternative envisagée, chaque couche de solution déposée subit, selon l'invention, une opération consistant à sécher la couche déposée de manière à assurer une gélification de la couche. Cette opération est destinée à assurer l'évaporation d'une partie du solvant du type diol et, le cas échéant, d'une partie du solvant de dilution et éventuellement des produits secondaires, tels que des esters, issus des réactions entre les précurseurs métalliques. A l'issue de cette opération, la solution sol-gel déposée est transformée totalement en une couche de gel d'épaisseur généralement constante adhérant à la surface du substrat. La température et la durée efficaces pour assurer la gélification peuvent être déterminées aisément, par l'homme du métier, à l'aide, par exemple, de techniques de spectrométrie IR.

Par exemple, l'opération de séchage, selon l'invention, peut être effectuée à une température inférieure à 100°C, par exemple à 50°C pour une durée allant de 1 à 10 minutes, par exemple, en utilisant une plaque chauffante.

Après séchage, chaque couche subit une opération de calcination effectuée à une température et une durée pour éliminer des composés organiques de la couche déposée et en particulier les solvants de préparation et de dilution de la solution sol-gel et les composés générés par la réaction des précurseurs moléculaires entre eux. La température et durée efficaces peuvent être déterminées aisément par l'homme du métier grâce à des techniques telles que la spectroscopie IR (Infra-rouge) ou l'analyse thermo-différentielle et thermo-gravimétrique (ATD-ATG).

La durée de calcination pour une température donnée, correspond à une durée permettant l'obtention d'une épaisseur de couche constante. L'épaisseur de couche est contrôlée, par exemple, par des techniques de profilométrie. L'opération de calcination est arrêtée à l'obtention d'une couche homogène en épaisseur et exempte de composés organiques.

De préférence, cette opération de calcination s'effectue à une température allant d'environ 300 à environ 380°C et pour une durée allant d'environ 30 secondes à environ 20 minutes.

Pour la n^{ième} couche, l'opération de pré-recuit consiste en un chauffage à une température allant jusqu'à 600°C, pendant une durée pouvant aller de 1 minute à 60 minutes, de préférence pendant une durée supérieure à 15 minutes, par exemple supérieure à 20 minutes.

Enfin, après l'opération de pré-recuit, le cas échéant, le traitement thermique comprend, classiquement, une opération de recuit réalisée à une durée et une température efficaces pour permettre la cristallisation de la couche déposée ou de l'ensemble des couches déposées. La cristallisation de la couche correspond à l'obtention d'une couche d'épaisseur stabilisée et de structure cristallisée, généralement du type pérovskite. La température et la durée de recuit sont choisies de manière à obtenir cette cristallisation, vérifiable aisément par analyse structurale, telle que l'analyse par diffraction des rayons X. De préférence, le recuit est effectué à une température allant d'environ 800 à environ 1000°C pour une durée comprise entre environ 30 secondes et environ 1 heure. Lorsque le procédé comprend le dépôt de plusieurs couches, l'opération de recuit est réalisée sur l'empilement complet de couches, chacune des (n-1) premières couches de l'empilement ayant subi préalablement une opération de séchage, une opération de calcination.

Le recuit peut être effectué par différentes techniques. De préférence, le recuit est réalisé par un mode de chauffage rapide, obtenu, par exemple, avec la technique du « recuit thermique rapide » (communément désigné par l'abréviation RTA pour « *Rapid Thermal Annealing* » ou RTP pour « *Rapid Thermal Process* »)*.*

Les étapes de dépôt de la solution sol-gel et de traitement thermique peuvent être réitérées une ou plusieurs fois, jusqu'à l'obtention d'un matériau présentant l'épaisseur désirée.

Le matériau obtenu se présente sous forme d'une couche ou d'un empilement de couches denses ne présentant pas de groupes carbonates par analyse infrarouge, l'élimination des groupes carbonates, au moment de la densification de la couche, induisant souvent une porosité dans les couches, dans lesquelles ils étaient présents.

L'invention a également trait à un procédé de fabrication d'une poudre de titanate de baryum dopé par du hafnium et/ou par au moins un élément lanthanide comprenant successivement les étapes suivantes :
- une étape de mise en œuvre du procédé de préparation d'une solution sol-gel tel que défini ci-dessus ;
- une étape de gélification d'une solution sol-gel obtenue selon le procédé conforme à l'invention ; et
- une étape de traitement thermique du gel obtenu pour obtenir ladite poudre.

L'étape de gélification est effectuée, classiquement, par ajout d'eau sous agitation, moyennant quoi il se produit des réactions d'hydrolyse-condensation au sein de la solution sol-gel, qui finit par se gélifier.

Le gel ainsi obtenu est soumis à un traitement thermique, de sorte à le transformer en une poudre de titanate de baryum dopé par de l'hafnium et/ou par au moins un élément lanthanide, ce traitement thermique pouvant comporter les opérations suivantes :
- une opération de séchage, par exemple, à l'étuve pour éliminer au moins une partie du solvant piégé dans le gel ;
- après broyage du bloc résultant du séchage du gel, une opération de calcination à une température efficace pour obtenir une élimination des produits organiques et une opération de recuit à une température efficace pour obtenir une cristallisation de la poudre en titane de baryum dopé par du hafnium et/ou par au moins un élément lanthanide, avantageusement, selon un système cristallin pérovskite.

La poudre ainsi obtenue peut être utilisée pour la fabrication d'objets compactés en titanate de baryum dopé par du hafnium et/ou par au moins un élément lanthanide, tels que des pastilles, selon un procédé comprenant les étapes suivantes :
- une étape de mise en œuvre du procédé de préparation d'une poudre tel que défini ci-dessus ;
- une étape de compactage de la poudre dans un moule présentant une forme correspondant à celle de l'objet compacté, que l'on souhaite obtenir ;
- une étape de frittage de l'objet obtenu ci-dessus en vue de le consolider.

Plus spécifiquement, l'étape de compactage peut être réalisée par pressage uniaxiale et peut être réalisée avec la poudre susmentionnée, à laquelle il a été mélangé un liant, tel qu'un alcool polyvinylique.

L'étape de frittage est réalisée, classiquement, à une température et une durée efficace pour obtenir une consolidation des grains et éventuellement une augmentation de la taille des grains. A titre d'exemple, lorsque l'étape de frittage est réalisée avec des pastilles de titanate de baryum dopé par du hafnium et/ou par au moins un élément lanthanide préalablement obtenues par pressage uniaxiale en présence d'un liant du type alcool polyvinylique, l'étape de frittage peut être réalisée à une température d'au moins 1300°C, de préférence, d'au moins 1500°C, pendant une durée d'au moins 5 heures.

Préalablement à l'étape de compactage, le procédé peut comprendre une étape d'attrition de la poudre, qui consiste à réduire la taille des grains constitutifs de la poudre par frottement.

De manière pratique, cette étape d'attrition peut consister à placer la poudre dans un bol d'attrition en présence de billes abrasives, telles que des billes de zircone, et d'un solvant pour créer une dispersion avec la poudre, ce solvant pouvant être un solvant alcoolique, tel que l'éthanol. Le mélange résultant dans le bol d'attrition est ensuite soumis à une agitation, jusqu'à obtenir la taille de grains souhaitée.

Il est à noter que le fait de diminuer la taille de grains de la poudre peut contribuer à augmenter la densité des objets compactés après frittage.

Enfin, l'invention a trait à la préparation d'une solution sol-gel dite composite, comprenant les étapes suivantes :
- une étape de mise en œuvre du procédé de préparation d'une solution sol-gel tel que défini ci-dessus ;
- une étape d'ajout à ladite solution sol-gel d'une poudre de titanate de baryum dopé par du hafnium et/ou par au moins un élément lanthanide, moyennant quoi l'on obtient une dispersion dans laquelle la poudre constitue la phase de dispersion, tandis que la solution sol-gel constitue le milieu continu de dispersion.

On précise que, par solution sol-gel composite, on entend aussi une dispersion comprenant une poudre de titanate de baryum dopée par du hafnium et/ou par au moins un élément lanthanide et une solution sol-gel précurseur de titanate de baryum dopé par du hafnium et/ou par au moins un élément lanthanide.

Avantageusement, la céramique oxyde constitutif de la poudre peut être de composition identique à celle de la céramique oxyde qui résultera du traitement thermique de la solution sol-gel dans laquelle la poudre est mise en dispersion.

La poudre selon l'invention est une poudre qui peut être disponible commercialement ou encore qui peut être préparée préalablement, et avantageusement, par voie sol-gel à partir d'une solution sol-gel identique à celle dans laquelle la poudre est dispersée, cette poudre étant, avantageusement, préparée selon un procédé conforme à l'invention et tel que défini ci-dessus.

Les poudres utilisées dans le cadre de cette invention présentent avantageusement un diamètre moyen de particules allant de 10 nm à 10 µm.

Avant incorporation dans la solution sol-gel mentionnée plus haut, elles peuvent être amenées à subir une étape de broyage, par exemple, par attrition, de manière à obtenir des grains plus fins.

Selon l'invention, la poudre peut être incorporée dans la solution sol-gel à une teneur pouvant aller jusqu'à 80% en masse du poids total de la dispersion, de préférence à une teneur allant de 10 à 60% en masse ou encore de 5 à 60% en masse.

Cette solution sol-gel composite peut être utilisée avantageusement pour la réalisation d'un matériau en titanate de baryum dopé par du hafnium et/ou par au moins un élément lanthanide, ce matériau pouvant être un revêtement épais sur un substrat, ce matériau pouvant être préparé par un procédé de préparation comprenant successivement les étapes suivantes :
a) préparer une solution sol-gel composite par un procédé tel que défini ci-dessus ;
b) déposer par voie liquide sur un substrat une couche d'une solution sol-gel composite telle que définie ci-dessus ;
c) répéter b), une ou plusieurs fois, de manière à obtenir un empilement d'au moins deux couches ;
d) traiter thermiquement lesdites couches en vue de les transformer en la (les) céramique(s) correspondante(s) ;
e) imprégner l'empilement obtenu en c) par une solution sol-gel identique ou différente de celle utilisée dans l'étape a) mais précurseur d'une céramique titanate de baryum dopé par du hafnium et/ou par au moins un élément lanthanide ;
f) éventuellement, répéter l'étape e) une ou plusieurs fois ;
g) traiter thermiquement ledit empilement, en vue de transformer la solution sol-gel imprégnant l'empilement en la céramique correspondante.

Le procédé de l'invention permet de s'affranchir d'un certain nombre d'inconvénients des procédés de l'art antérieur. En effet, l'étape d'imprégnation par une solution sol-gel de la totalité de l'empilement et non couche par couche, contribue à simplifier considérablement les procédés de l'art antérieur.

Selon l'invention, le procédé comprend, dans un premier temps, une étape de dépôt sur un substrat d'une couche d'une solution sol-gel composite telle que définie ci-dessus, les techniques de dépôt utilisées pouvant être le trempage-retrait (connu sous la terminologie anglaise « *dip-coating* »), l'enduction centrifuge (connue sous la terminologie anglaise « *spin-coating* »), l'enduction laminaire (connue sous la terminologie anglaise « *laminar-flow-coating ou meniscus coating* »), la projection pneumatique (connue sous la terminologie anglaise « *spray-coating* »), l'enduction à la racle (connue sous la terminologie anglaise « *doctor blade coating* »), le dépôt par jet d'encre avec, toutefois, une préférence pour la technique du trempage-retrait.

En effet, la technique du trempage-retrait permet d'obtenir d'excellents résultats et permet notamment de faire des dépôts sur des substrats à forme complexe.

Le substrat sur lequel l'on dépose la couche de dispersion peut être de différents types.

Avantageusement, ce substrat ne doit pas contaminer la couche déposée, par migrations d'ions par exemple, lors des traitements thermiques et doit permettre une bonne adhérence de la couche. Avantageusement, sa température de ramollissement doit être supérieure à la température des traitements thermiques des couches déposées et son coefficient de dilatation thermique doit être compatible avec celui desdites couches pour limiter les effets de contrainte lors des traitements thermiques.

En particulier, il peut être choisi parmi les substrats en acier inoxydable ; en acier comprenant du nickel ; en silicium éventuellement métallisé ; en aluminium ; en céramique, telle que de la zircone (par exemple, une zircone dopée par de l'yttrium ou de l'oxyde d'yttrium), du titanate de baryum dopé au hafnium (nommé aussi par l'abréviation BHT) ; en titane ; en carbone ; en verre ou en polymère.

Notamment, lorsque les substrats sont à base de métal, tels que les substrats en acier, en aluminium ou en titane, il peut être avantageux de déposer sur la face du substrat, (qui sert de support au dépôt de la couche de dispersion), une couche dense d'un oxyde choisi, par exemple, parmi SiO₂, Ta₂O₅, ZrO₂, Al₂O₃, TiO₂, PZT, BST et des combinaisons de celles-ci.

Cette couche assurera le rôle d'une couche barrière et empêchera ainsi la diffusion des atomes appartenant au substrat, lors du traitement thermique vers l'empilement de couches. Cette couche servant de barrière peut être obtenue par dépôt sur le substrat d'une solution sol-gel précurseur de la (les) céramique(s) oxyde(s) constitutif(s) de cette couche, le dépôt d'une telle solution sol-gel pouvant se faire selon l'une des techniques de dépôts par voie liquide mentionnées ci-dessus.

La dispersion préparée est ensuite déposée sous forme de couche par voie liquide (tel qu'explicité ci-dessus) sur un substrat tel que défini ci-dessus.

Le choix de la vitesse de dépôt est réalisé en fonction de l'épaisseur de la couche souhaitée.
Généralement, l'épaisseur de chaque couche déposée va de 1 à 50 µm, par exemple, de 1 à 25 µm.

Dans le cas de la technique du tremprage-retrait, le substrat à recouvrir est plongé dans la dispersion préparée précédemment puis retiré à une vitesse prédéterminée. La vitesse de retrait se situe, généralement, entre 1 cm/min et 30 cm/min. Les techniques de dépôt par voie liquide comme l'enduction centrifuge, l'enduction laminaire ou le trempage-retrait présentent l'avantage de permettre un contrôle précis de l'épaisseur des couches déposées.

Cette étape de dépôt est répétée une ou plusieurs fois de manière à obtenir un empilement d'au moins deux couches et pouvant aller, par exemple, jusqu'à 50 couches, de préférence de 2 à 10 couches. Le nombre de répétition de cette étape sera fixé par l'homme du métier en fonction de l'épaisseur d'empilement souhaité, l'épaisseur de l'empilement pouvant être supérieure à 1 µm et, plus spécifiquement pouvant aller de 1 µm à 200 µm, de préférence, de 1 µm à 50 µm.

Le procédé de l'invention comprend également une étape de céramisation par traitement thermique desdites couches, c'est-à-dire une étape de traitement thermique de la dispersion susmentionnée, en vue de transformer la solution sol-gel en la céramique correspondante.

Selon une première alternative, le traitement thermique peut être mise en œuvre couche par couche. Dans ce cas, le traitement thermique comprend généralement successivement:
- une opération de séchage de la couche à une température appropriée pour obtenir une gélification de celle-ci ;
- une opération de calcination à une température appropriée pour obtenir une élimination des produits organiques compris dans la couche ;
- une opération de recuit à une température appropriée pour obtenir une cristallisation en céramique oxyde de la couche.

Ce traitement thermique est réitéré à chaque couche déposée, c'est-à-dire autant de fois qu'il y a de couches déposées.

Selon l'invention, l'on peut prévoir également de finaliser ce traitement thermique par une opération de recuit de l'ensemble de l'empilement.

Selon une seconde alternative, le traitement thermique peut se dérouler de la façon suivante :
- une opération de séchage de chaque couche déposée ;
- une opération de calcination de chaque couche déposée ;
- une opération de recuit toutes les n couches déposées, n allant de 2 jusqu'au nombre total de couches déposées.

Quelle que soit l'alternative envisagée, le séchage se déroule généralement à une température inférieure à 100°C. Ce séchage permet un rapprochement des précurseurs compris dans la solution sol-gel et une condensation de ceux-ci pour former un gel. Lors de cette condensation, des produits organiques sont libérés, tel que des alcools, des carbonates. L'opération de calcination, destinée à l'élimination des produits organiques résultant de la condensation des précurseurs moléculaires, est généralement mise en œuvre à des températures supérieures à 350°C, par exemple à une température de 360 à 400°C pour éliminer les produits organiques avec création de carbonates le cas échéant.

Enfin, l'opération de recuit est généralement réalisée à une température supérieure d'au moins 750°C, de préférence, d'au moins 800°C, de préférence encore d'au moins 900°C, de manière à cristalliser les couches.

Une fois l'empilement réalisé, le procédé selon l'invention prévoit une étape d'imprégnation de l'empilement complet par une solution sol-gel précurseur d'une céramique du type titanate de baryum dopé au hafnium et/ou par au moins un élément lanthanide (cette solution sol-gel étant dénuée de poudre), identique ou différente de celle utilisée dans la première étape, cette étape d'imprégnation étant répétée une ou plusieurs fois. Cette solution précurseur est de même nature ou différente de celle utilisée en tant que milieu continu de dispersion dans l'étape de dépôt susmentionnée. De préférence, la solution sol-gel d'imprégnation est obtenue par le procédé de l'invention susmentionné, une telle solution sol-gel permettant notamment de boucher les pores présents à la surface de l'empilement (sans l'infiltrer totalement) et aussi d'imperméabiliser la surface de l'empilement. De cette manière, l'empilement résultant peut être utilisé pour des applications piézoélectriques.

Cette étape d'imprégnation peut être réitérée une ou plusieurs fois, par exemple jusqu'à 10 fois. Par exemple, l'homme du métier déterminera le nombre d'étapes d'imprégnation à mettre en œuvre, de manière à obtenir un état de surface le moins rugueux possible. Par exemple, il pourra fixer le nombre d'étape d'imprégnation, de manière à obtenir, à l'issue de ces imprégnations, une rugosité de l'état de surface de l'empilement divisée, par exemple, par 2 par rapport à l'empilement non imprégné, la mesure de la rugosité étant effectuée par le biais d'un profilomètre. Ces étapes d'imprégnation sont effectuées par voie liquide, selon des techniques mentionnées ci-dessus, avec de préférence, la technique de trempage-retrait.

L'empilement ainsi imprégné est ensuite traité thermiquement, de façon à transformer la solution sol-gel précurseur imprégnant l'empilement en la céramique oxyde correspondante.

Selon une première alternative, le traitement thermique peut intervenir à la fin de chaque étape d'imprégnation. Dans ce cas, il comprend généralement une opération de séchage, généralement, à une température inférieure à 100°C, suivie généralement d'une opération de calcination destinée à éliminer les produits organiques et éventuellement les carbonates issus de la transformation de la solution sol-gel en gel, cette opération se déroulant généralement à une température supérieure à 300°C, et/ou enfin une opération de recuit destinée à cristalliser la céramique oxyde, cette opération se déroulant généralement à une température supérieure à 600°C.

Selon une seconde alternative, le traitement thermique peut comprendre successivement :
- une opération de séchage à chaque imprégnation;
- une opération de calcination à chaque imprégnation;
- une opération de recuit toutes les m imprégnations, m allant de 2 jusqu'au nombre total d'imprégnations.

L'empilement résultant de ce procédé résulte en un revêtement épais (notamment, d'épaisseur supérieure à 1 µm) présentant des propriétés piézoélectriques, lequel peut être utilisé pour l'élaboration de transducteurs haute fréquence pour l'imagerie médicale.

En variante, la solution sol-gel composite obtenue selon le procédé de l'invention peut être utilisée directement pour être mise en forme, par jet d'encre ou usinage, par exemple, sous forme de barrettes multiéléments qui seront intégrées, comme transducteurs, dans des sondes ultrasonores haute résolution pour l'imagerie médicale (telle que l'échographie).

L'invention va être, à présent, décrite à la lumière des exemples exposés ci-dessus, ces exemples n'étant fournis qu'à titre d'illustration de l'invention et n'en constituant en aucun cas une limitation.

### EXPOSÉ DÉTAILLÉ DE MODES DE RÉALISATION PARTICULIERS

### EXEMPLE 1

Cet exemple illustre la préparation de pastilles en titanate de baryum dopé par de l'hafnium, et plus spécifiquement, répondant à la formule BaH_{f0,05}Ti_{0,95}O₃, cette préparation comprenant les étapes suivantes :
- une étape de préparation d'une solution sol-gel précurseur du titanate de baryum de formule mentionnée ci-dessus (étape a)
- une étape de préparation d'une poudre à partir de la solution sol-gel issue de l'étape a (étape b) ;
- une étape de préparation des pastilles à partir de la poudre obtenue à l'étape b (étape c).

### a) Préparation d'une solution sol-gel précurseur du titanate de baryum de formule BaH_{f0,05}Ti_{0,95}O₃

Cette étape illustre la préparation d'une solution sol-gel précurseur du titanate de baryum de formule BaH_{f0,05}Ti_{0,95}O₃ à partir des précurseurs alcoxydes suivants : l'isopropoxyde de titane symbolisé Ti(OiPr)₄, l'isopropoxyde d'hafnium symbolisé Hf(OiPr)₄ et l'acétate de baryum symbolisé Ba(OAc)₂.

Dans un premier ballon, on ajoute respectivement, de l'isopropoxyde de titane (6,67 g ; 0,0234 mole), de l'isopropoxyde d'hafnium (0,9 g; 0,00217 mole) à de l'isopropanol (5 g; 0,083 mole). L'ensemble est agité pendant 1 heure pour bien disperser l'isopropoxyde d'hafnium en solution.

En parallèle, dans un second ballon surmonté d'un montage de distillation, on ajoute de l'acétate de baryum (6,48 g ; 0,0255 mole)) dans de l'éthylène glycol (14,68 g ; 0,236 mole) sous agitation, de sorte à éviter la formation d'un bloc insoluble. Au mélange résultant, on ajoute le contenu du premier ballon à l'issue de l'opération d'agitation susmentionnée. L'ensemble est ensuite distillé jusqu'à ce que la température du milieu réactionnel atteigne 160°C. A l'issue de la distillation, la solution est opaque. On constate, par analyse infrarouge, l'élimination de 90% massique de l'isopropanol et la formation d'esters.

Une fois la température revenue à 100°C, on ajoute au distillat de l'acide acétique (14 g ; 0,23 mole) lentement jusqu'à dissolution totale des précurseurs non dissous et l'obtention d'une solution jaune limpide.

A la solution sol-gel est ajoutée une quantité importante d'eau sous agitation pour former un gel. Le gel est ensuite séché à l'étuve.

La poudre récupérée à l'étuve est broyée puis calcinée à 400°C pour éliminer les composants organiques résiduels, sources de carbonatation.

La poudre obtenue est, de nouveau, broyée et recuite cette fois à 900°C, pour obtenir une poudre de titanate de baryum dopée à l'hafnium cristallisé selon un système cristallin pérovskite.

La poudre est ensuite soumise à une opération d'attrition dans un bol d'attrition, dans lequel il est placé 75 g de poudre, 150 g d'éthanol et 1600 g de billes en zircone, le mélange résultant étant mis sous agitation pendant 20 minutes à 1500 tours/minute. A l'issue de cette opération, l'on récupère une poudre plus fine, qui peut être utilisée pour des pastilles, qui présenteront une densité plus importante après frittage, par rapport à des pastilles réalisées avec des poudres non attritées.

L'élaboration des pastilles est effectuée à l'aide d'une presse uniaxiale. Pour ce faire, un liant (plus spécifiquement, de l'alcool polyvinylique) est ajouté à la poudre, le mélange résultant étant placé dans un moule de 16 mm et pressé à 20 MPa. Les pastilles ainsi formées sont ensuite frittées à 1500°C pendant 5 heures.

La caractérisation de ces pastilles est effectuée par mesure d'impédance, après avoir polarisé les pastilles en bain d'huile sous champs (150°C ; 2 kV/mm).

Les propriétés piézoélectriques obtenues sont particulièrement intéressantes, avec notamment une valeur de kₜ (correspondant à la constante de couplage en mode épaisseur, qui correspond, approximativement, au rapport entre l'énergie mécanique fournie et l'énergie mécanique reçue) de 0,47 et une constante diélectrique de 840 (à 1,8 MHz).

### EXEMPLE 2

Cet exemple illustre la préparation de pastilles en titanate de baryum dopé par de l'hafnium, et plus spécifiquement, répondant à la formule BaH_{f0,1}Ti_{0,9}O₃, la préparation étant réalisée selon des modalités similaires à celles de l'exemple 1, si ce n'est au niveau des quantités de réactifs, qui sont les suivantes :
- Acétate de baryum : 6,48 g ;
- Isopropoxyde de titane : 6,49 g ;
- Isopropoxyde d'hafnium : 1,2 g ;
- Ethylène glycol : 14,68 g ;
- Isopropanol : 5 g ; et
- Acide acétique : 14 g.

Qui plus, les pastilles sont frittées à une température de 1350°C à partir de poudres n'ayant pas subi un traitement d'attrition.

Ces pastilles présentent une constante diélectrique de 1230.

### EXEMPLE 3

Cet exemple illustre la préparation d'une solution sol-gel précurseur du titanate de baryum dopé par du hafnium de formule BaH_{f0,075}Ti_{0,925}O₃, la préparation étant réalisée selon des modalités similaires à celles de l'exemple 1, si ce n'est au niveau des quantités de réactifs, qui sont les suivantes :
- Acétate de baryum : 6,48 g ;
- Isopropoxyde de titane : 6,67 g ;
- Isopropoxyde d'hafnium : 0,90 g ;
- Ethylène glycol : 14,68 g ;
- Isopropanol : 5 g ; et
- Acide acétique : 14 g.

### EXEMPLE 4

Cet exemple illustre la préparation d'un matériau sous forme d'une couche mince à partir des solutions sol-gel préparées selon les exemples 1, 2 et 3, qui ont été toutes mûries pendant 45 jours et présentant chacunes une concentration de 0,9 M.

Avant de procéder au dépôt, la solution sol-gel concernée est diluée avec de l'éthylène glycol (40 mL) pour notamment adapter la mouillabilité et la viscosité de la solution au substrat et aux conditions de dépôt, le substrat étant dans le cadre de cet exemple un morceau de wafer de silicium platiné (Si 500µm/SiO2 2,5µm/Ti 15 nm/Pt 150 nm) et la technique de dépôt utilisée dans cet exemple étant l'enduction centrifuge.

La solution sol-gel ainsi diluée est ensuite déposée par enduction centrifuge pendant 3 minutes à 3000 tours/minute puis séché, sur plaque chauffante, d'abord 5 minutes à 50°C puis 10 minutes à 360°C. Plusieurs couches (au nombre de 3) sont empilées selon le même traitement puis l'empilement résultant est traité thermiquement à 600°C sur plaque chauffante suivi d'un recuit au four (dit recuit RTA pour « Rapid Thermal Annealing ») 1 minute à 750°C. Le revêtement ainsi obtenu ne présente pas de groupements carbonates, lorsqu'il est soumis à une analyse infrarouge, ce qui atteste d'une forte densité du revêtement ainsi obtenu.

Le revêtement ainsi obtenu présente également une forte permittivité à 1 kHz, respectivement, 200 pour un film issu de la solution sol-gel de l'exemple 1 (e = 180 nm), 231 pour un film issu de la solution sol-gel de l'exemple 3 (e = 500 nm), 215 pour un film issu de la solution sol-gel de l'exemple 2 (e = 400 nm), ce qui peut être particulièrement intéressant pour la microélectronique.

### EXEMPLE 5

La solution de l'exemple 1 est mûrie pendant 45 jours puis est diluée avec de l'éthylène glycol pour obtenir une solution de concentration 0.4 M. Pour ce faire, on ajoute 12 mL d'éthylène glycol à 10 ml de la solution ainsi mûrie. Ensuite, on mélange 50 grammes cette solution et 5,5 grammes de poudre de titanate de baryum dopé par du hafnium préparée selon le protocole de l'exemple 1. La solution composite est laissée sous agitation pendant 40 jours. On réalise ensuite le dépôt de l'empilement par trempage retrait à la vitesse de 5 cm/min (5 couches). Un traitement thermique à 600°C (5 minutes), sur plaque chauffante a lieu à chaque couche. On procède ensuite à un recuit final à 900°C (2 minutes), en four RTA, sur l'empilement complet.

Les films sont ensuite imprégnés avec un sol non chargé, de concentration 0,5 M. On réalise un traitement thermique à 600°C, sur plaque chauffante, pendant 1 heure, à chaque couche d'imprégnation. Un recuit final, en four RTA, à 900°C, a ensuite lieu, pendant 2 minutes.

On dépose des électrodes d'aluminium sur la couche composite, d'épaisseur 45 µm et elle est caractérisée électromécaniquement. Le coefficient de couplage mesuré est de 0,45, c'est-à-dire proche de celui du matériau volumique.

## Revendications

1. Procédé de préparation d'une solution sol-gel utilisable pour la préparation d'une céramique de titanate de baryum dopé par du hafnium et/ou par au moins un élément lanthanide comprenant les étapes suivantes :
a) une étape de mise en contact d'un premier mélange comprenant un carboxylate de baryum et un solvant diol et d'un deuxième mélange comprenant un alcoxyde de titane et un alcoxyde de hafnium et/ou un alcoxyde d'un élément lanthanide dans un solvant monoalcoolique ;
b) une étape de distillation du mélange résultant de l'étape a), en vue d'éliminer au moins une partie du solvant monoalcoolique ;
c) une étape d'ajout, à chaud, d'acide acétique au mélange distillé de l'étape b).

2. Procédé de préparation selon la revendication 1, dans lequel la céramique de titanate de baryum est dopé uniquement par du hafnium, auquel cas le deuxième mélange comprend un alcoxyde de titane et un alcoxyde de hafnium.

3. Procédé selon la revendication 1, dans lequel le carboxylate de baryum est représenté par la formule (II) suivante :
(RCOO)₂Ba (II)
dans laquelle R représente un groupe alkyle comprenant de 1 à 3 atomes de carbone.

4. Procédé selon l'une quelconque des revendications précédentes, dans lequel le solvant diol est un alkylène glycol, ayant un nombre d'atomes de carbone allant de 2 à 5.

5. Procédé selon l'une quelconque des revendications précédentes, dans lequel l'alcoxyde de hafnium et/ou l'alcoxyde d'élément lanthanide et l'alcoxyde de titane présents dans le deuxième mélange répondent respectivement aux formules (II) et (III) suivantes : 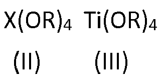 dans lesquelles :
- X représente l'élément hafnium ou l'élément lanthanide ;
- R réprésente un groupe alkyle linéaire ou ramifié et plus spécifiquement un groupe alkyle ramifié comportant au moins 3 atomes de carbone.

6. Procédé selon l'une quelconque des revendications précédentes, dans lequel l'alcoxyde de hafnium et l'alcoxyde de titane sont, respectivement, de l'isopropoxyde de hafnium et de l'isopropoxyde de titane.

7. Procédé selon l'une quelconque des revendications précédentes, dans lequel le solvant monoalcoolique est un solvant monoalcoolique aliphatique comprenant de 1 à 6 atomes de carbone.

8. Procédé selon l'une quelconque des revendications précédentes, dans lequel le solvant monoalcoolique comporte un nombre d'atomes de carbone identique à celui de chaque ligand alcoxy (RO) des alcoxydes de formules (II) et (III) définies à la revendication 5.

9. Procédé selon l'une quelconque des revendications précédentes, dans lequel le titanate de baryum dopé par du hafnium répond à la formule (IV) suivante :
BaHfₓTi₁₋ₓO₃ (IV)
dans laquelle 0,05 <x≤ 0,2.

10. Procédé selon l'une quelconque des revendications précédentes, comprenant à l'issue de l'étape c), successivement les étapes suivantes :
d) une étape d'agitation de la solution sol-gel obtenue à l'étape c) ; et
e) une étape de dilution à un taux prédéterminé de la solution sol-gel issue de l'étape d) avec un solvant diol identique à celui de l'étape a).

11. Procédé de fabrication d'un matériau en titanate de baryum dopé par du hafnium et/ou par au moins un élément lanthanide, ledit procédé comprenant :
f) une étape de mise en œuvre du procédé tel que défini selon l'une quelconque des revendications 1 à 10 ;
g) au moins une étape de dépôt d'une couche d'une solution sol-gel obtenue à l'étape f) sur un substrat;
h) une étape de traitement thermique de ladite couche en vue de la transformer en titanate de baryum dopé par du hafnium et/ou par au moins un élément lanthanide.

12. Procédé de fabrication d'une poudre de titanate de baryum dopé par du hafnium et/ou par au moins un élément lanthanide comprenant successivement les étapes suivantes :
- une étape de mise en œuvre du procédé tel que défini selon l'une quelconque des revendications 1 à 10 ;
- une étape de gélification d'une solution sol-gel obtenue à l'étape précédente ;
- une étape de traitement thermique du gel obtenu pour obtenir ladite poudre.

13. Procédé de fabrication d'un objet compacté en titanate de baryum dopé par du hafnium comprenant successivement les étapes suivantes :
- une étape de mise en œuvre du procédé de préparation d'une poudre tel que défini à la revendication 12 ;
- une étape de compactage de la poudre dans un moule présentant une forme correspondant à celle de l'objet compacté, que l'on souhaite obtenir ; et
- une étape de frittage de l'objet obtenu ci-dessus en vue de le consolider.

14. Procédé de préparation d'une solution sol-gel, dite composite, comprenant les étapes suivantes :
- une étape de mise en œuvre du procédé de préparation d'une solution sol-gel tel que défini selon l'une quelconque des revendications 1 à 10 ;
- une étape d'ajout à ladite solution sol-gel d'une poudre de titanate de baryum dopé par du hafnium et/ou par au moins un élément lanthanide, moyennant quoi l'on obtient la solution sol-gel composite, qui consiste en une dispersion dans laquelle la poudre constitue la phase de dispersion, tandis que la solution sol-gel constitue le milieu continu de dispersion.

15. Procédé de préparation d'un matériau en titanate de baryum dopé par du hafnium et/ou par au moins un élément lanthanide comprenant successivement les étapes suivantes :
a) préparer une solution sol-gel composite par un procédé tel que défini selon la revendication 14 ;
b) déposer par voie liquide sur un substrat une couche d'une solution sol-gel composite telle que définie ci-dessus ;
c) répéter b), une ou plusieurs fois, de manière à obtenir un empilement d'au moins deux couches ;
d) traiter thermiquement lesdites couches en vue de les transformer en la (les) céramique(s) correspondante(s) ;
e) imprégner l'empilement obtenu en c) par une solution sol-gel identique ou différente de celle utilisée dans l'étape a) mais précurseur d'une céramique titanate de baryum dopé par du baryum et/ou par au moins un élément lanthanide ;
f) éventuellement, répéter l'étape e) une ou plusieurs fois ;
g) traiter thermiquement ledit empilement, en vue de transformer la solution sol-gel imprégnant l'empilement en la céramique correspondante.

## Patentansprüche

1. Verfahren zur Herstellung einer Sol-Gel-Lösung, die für die Herstellung einer Bariumtitanatkeramik verwendbar ist, die mit Hafnium und/oder mit wenigstens einem Lanthanidelement dotiert ist, umfassend die folgenden Schritte:
a) einen Schritt des Inkontaktbringens einer ersten Mischung, umfassend ein Bariumcarboxylat und ein Diollösungsmittel, und einer zweiten Mischung, umfassend ein Titanalcoxyd und ein Hafniumalcoxyd und/oder ein Alcoxyd eines Lanthanidelements, in einem monoalkoholischen Lösungsmittel;
b) einen Schritt des Destillierens der Mischung, die aus dem Schritt a) resultiert, um wenigstens einen Teil des monoalkoholischen Lösungsmittels zu entfernen;
c) einen Schritt des Hinzufügens, in heißem Zustand, von Essigsäure zu der destillierten Mischung des Schritts b).

2. Herstellungsverfahren nach Anspruch 1, bei dem die Bariumtitanatkeramik ausschließlich mit Hafnium dotiert ist, in welchem Fall die zweite Mischung ein Titanalcoxyd und ein Hafniumalcoxyd umfasst.

3. Verfahren nach Anspruch 1, bei dem das Bariumcarboxylat durch die nachfolgende Formel (II) repräsentiert ist:
(RCOO)₂Ba (II)
wobei R eine Alkylgruppe repräsentiert, die 1 bis 3 Kohlenstoffatome umfasst.

4. Verfahren nach einem der vorhergehenden Ansprüche, bei dem das Diollösungsmittel ein Alkylenglycol ist, das eine Zahl von Kohlenstoffatomen von 2 bis 5 hat.

5. Verfahren nach einem der vorhergehenden Ansprüche, bei dem das Hafniumalcoxyd und/oder das Alcoxyd eines Lanthanidelements und das Titanalcoxyd, die in der zweiten Mischung vorhanden sind, den nachfolgenden Formeln (II) beziehungsweise (III) entsprechen: 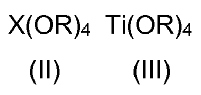 wobei:
- X das Element Hafnium oder das Lanthanidelement repräsentiert;
- R eine lineare oder verzweigte Alcylgruppe repräsentiert, und spezieller eine verzweigte Alcylgruppe, die wenigstens 3 Kohlenstoffatome umfasst.

6. Verfahren nach einem der vorhergehenden Ansprüche, bei dem das Hafniumalcoxyd und das Titanalcoxyd Hafniumisopropoxyd beziehungsweise Titanisopropoxyd sind.

7. Verfahren nach einem der vorhergehenden Ansprüche, bei dem das monoalkoholische Lösungsmittel ein aliphatisches monoalkoholisches Lösungsmittel ist, das von 1 bis 6 Kohlenstoffatomen umfasst.

8. Verfahren nach einem der vorhergehenden Ansprüche, bei dem das monoalkoholische Lösungsmittel eine Zahl von Kohlenstoffatomen umfasst, die identisch ist zu jener von jedem Alcoxyliganden (RO) der Alcoxyde mit den in Anspruch 5 definierten Formeln (II) und (III).

9. Verfahren nach einem der vorhergehenden Ansprüche, bei dem das mit Hafnium dotierte Bariumtitanat der nachfolgenden Formel (IV) entspricht:
BaHfₓTi₁₋ₓO₃ (IV)
wobei 0,05<x ≤0,2.

10. Verfahren nach einem der vorhergehenden Ansprüche, umfassend nach dem Schritt c) sukzessive die folgenden Schritte:
d) einen Schritt des Rührens der im Schritt c) erhaltenen Sol-Gel-Lösung; und
e) einen Schritt des Verdünnens der aus dem Schritt d) hervorgegangenen Sol-Gel-Lösung mit einem Diollösungsmittel, das identisch zu jenem des Schritts a) ist, auf eine vorbestimmte Rate.

11. Verfahren zur Herstellung eines Materials aus Bariumtitanat, das mit Hafnium und/oder mit wenigstens einem Lanthanidelement dotiert ist, wobei das Verfahren Folgendes umfasst:
f) einen Schritt des Durchführens des Verfahrens wie in einem der Ansprüche 1 bis 10 definiert;
g) wenigstens einen Schritt des Aufbringens einer Schicht einer Sol-Gel-Lösung, erhalten im Schritt f), auf ein Substrat;
h) einen Schritt des thermischen Behandelns der Schicht, um sie in Bariumtitanat zu transformieren, das mit Hafnium und/oder mit wenigstens einem Lanthanidelement dotiert ist.

12. Verfahren zur Herstellung eines Pulvers von Bariumtitanat, das mit Hafnium und/oder mit wenigstens einem Lanthanidelement dotiert ist, umfassend sukzessive die folgenden Schritte:
- einen Schritt des Durchführens des Verfahrens wie in einem der Ansprüche 1 bis 10 definiert;
- einen Schritt des Gelierens einer Sol-Gel-Lösung, die im vorhergehenden Schritt erhalten wird;
- einen Schritt des thermischen Behandelns des erhaltenen Gels, um das Pulver zu erhalten.

13. Verfahren zur Herstellung eines kompaktierten Objekts aus Bariumtitanat, das mit Hafnium dotiert ist, umfassend sukzessive die folgenden Schritte:
- einen Schritt des Durchführens des Verfahrens zur Herstellung eines Pulvers wie in Anspruch 12 definiert;
- einen Schritt des Kompaktierens des Pulvers in einer Form, die eine Gestalt entsprechend jener des kompaktierten Objekts aufweist, das man erhalten möchte; und
- einen Schritt des Sinterns des vorstehend erhaltenen Objekts, um es zu verfestigen.

14. Verfahren zur Herstellung einer Sol-Gel-Lösung, genannt Komposit, umfassend die folgenden Schritte:
- einen Schritt des Durchführens des Verfahrens zur Herstellung einer Sol-Gel-Lösung wie in einem der Ansprüche 1 bis 10 definiert;
- einen Schritt des Hinzufügens, zu der Sol-Gel-Lösung, eines Pulvers von Bariumtitanat, das mit Hafnium und/oder mit wenigstens einem Lanthanidelement dotiert ist, wodurch man die Sol-Gel-Kompositlösung erhält, bestehend aus einer Dispersion, in der das Pulver die Dispersionsphase bildet, wohingegen die Sol-Gel-Lösung das kontinuierliche Dispersionsmilieu bildet.

15. Verfahren zur Herstellung eines Materials aus Bariumtitanat, das mit Hafnium und/oder mit wenigstens einem Lanthanidelement dotiert ist, umfassend sukzessive die folgenden Schritte:
a) Herstellen einer Sol-Gel-Kompositlösung durch ein Verfahren wie in Anspruch 14 definiert;
b) Aufbringen einer Schicht einer Sol-Gel-Kompositlösung wie vorstehend definiert auf flüssigem Wege auf ein Substrat;
c) Wiederholen von b) ein oder mehrere Male derart, dass ein Stapel von wenigstens zwei Schichten erhalten wird;
d) thermisches Behandeln der Schichten, um sie in die entsprechende(n) Keramik(en) zu transformieren;
e) Imprägnieren des in c) erhaltenen Stapels mit einer Sol-Gel-Lösung, die identisch zu oder verschieden von jener ist, die im Schritt a) verwendet wird, aber Präkursor einer Bariumtitanatkeramik ist, dotiert mit Barium und/oder mit wenigstens einem Lanthanidelement;
f) gegebenenfalls Wiederholen des Schritts e) ein oder mehrere Male;
g) thermisches Behandeln des Stapels, um die Sol-Gel-Lösung, die den Stapel imprägniert, in die entsprechende Keramik zu transformieren.

## Claims

1. Method for preparing a sol-gel solution which can be used to prepare a barium titanate ceramic doped with hafnium and/or with at least one lanthanide element, comprising the following steps:
a) a step to place a first mixture comprising a barium carboxylate and a diol solvent in contact with a second mixture comprising a titanium alkoxide and a hafnium alkoxide and/or an alkoxide of a lanthanide element in a monoalcohol solvent;
b) a step to distil the mixture resulting from step a) to remove at least part of the monoalcohol solvent;
c) a step to add acetic acid, under heat, to the distilled mixture of step b).

2. The preparation method according to claim 1, wherein the barium titanate ceramic is doped solely with hafnium, in which case the second mixture comprises a titanium alkoxide and a hafnium alkoxide.

3. The method according to claim 1, wherein the barium carboxylate is represented by following formula (II)
(RCOO)₂Ba (II)
where R is an alkyl group having 1 to 3 carbon atoms.

4. The method according to any of the preceding claims, wherein the diol solvent is an alkylene glycol having a number of carbon atoms ranging from 2 to 5.

5. The method according to any of the preceding claims, wherein the hafnium alkoxide and/or lanthanide element alkoxide and titanium alkoxide contained in the second mixture respectively meet following formulas (II) and (III): 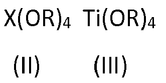 where:
- X is the hafnium element or lanthanide element;
- R is a linear or branched alkyl group and more specifically a branched alkyl group having at least 3 carbon atoms.

6. The method according to any of the preceding claims, wherein the hafnium alkoxide and titanium alkoxide are hafnium isopropoxide and titanium isopropoxide respectively.

7. The method according to any of the preceding claims, wherein the monoalcohol solvent is an aliphatic monoalcohol solvent having 1 to 6 carbon atoms.

8. The method according to any of the preceding claims, wherein the monoalcohol solvent has the same number of carbon atoms as each alkoxy ligand (RO) of the alkoxides of formulas (II) and (III) defined in claim 5.

9. The method according to any of the preceding claims, wherein the barium titanate doped with hafnium meets following formula (IV):
BaHfₓTi₁₋ₓO₃ (IV)
where 0.05 <x≤ 0.2.

10. The method according to any of the preceding claims which, after step c), successively comprises the following steps:
d) a step to agitate the sol-gel solution obtained at step c); and
e) a step to dilute the sol-gel solution resulting from step d) in a predetermined ratio with a diol solvent the same as the one used at step a).

11. Method for producing a material in barium titanate doped with hafnium and/or with at least one lanthanide element, said method comprising:
f) a step to implement the method such as defined in any of claims 1 to 10;
g) at least one step to deposit on a substrate a layer of sol-gel solution obtained at step f);
h) a heat treatment step of said layer for conversion thereof to barium titanate doped with hafnium and/or with at least one lanthanide element.

12. Method for producing a powder of barium titanate doped with hafnium and/or with at least one lanthanide element, successively comprising the following steps:
- a step to implement the method such as defined in any of claims 1 to 10;
- a gelling step of a sol-gel solution obtained at the preceding step;
- a heat treatment step of the resulting gel to obtain said powder.

13. Method for producing a compacted object in barium titanate doped with hafnium, successively comprising the following steps:
- a step to implement the method for preparing a powder such as defined in claim 12;
- a step to compact the powder in a mould having a shape corresponding to that of the compacted object it is desired to obtain; and
- a step to sinter the object obtained above for consolidation thereof.

14. Method for preparing a so-called composite sol-gel solution, comprising the following steps:
- a step to implement the method for preparing a sol-gel solution such as defined in any of claims 1 to 10;
- a step to add to said sol-gel solution a powder of barium titanate doped with hafnium and/or with at least one lanthanide element, after which the composite sol-gel solution is obtained consisting of a dispersion in which the powder forms the dispersion phase whilst the sol-gel solution forms the continuous dispersion medium.

15. Method for preparing a material in barium titanate doped wit hafnium and/or with at least one lanthanide element, successively comprising the following steps:
a) preparing a composite sol-gel solution with a method such as defined in claim 14;
b) depositing a layer of a composite sol-gel solution such as defined above via liquid process on a substrate;
c) repeating b) one or more times to obtain a stack of at least two layers;
d) heat treating said layers for conversion thereof to the corresponding ceramic(s);
e) impregnating the stack obtained at c) with a sol-gel solution the same as or differing from that used at a) but is a precursor of a barium titanate ceramic doped with hafnium and/or with at least one lanthanide element;
f) optionally repeating step e) one or more times;
g) heat treating said stack to convert the sol-gel solution impregnating the stack to the corresponding ceramic.
